(19)

Europäisches
Patentamt

European
Patent Office

Office européen
des brevets

(11) **EP 2 883 623 A2**

(12) **EUROPEAN PATENT APPLICATION**

(43) Date of publication:
**17.06.2015 Bulletin 2015/25**

(51) Int Cl.:
***B06B 1/06*** *(2006.01)*    ***H01L 41/09*** *(2006.01)*

(21) Application number: **14195111.1**

(22) Date of filing: **27.11.2014**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME** | (72) Inventor: **Tsuruno, Jiro**<br>**Suwa-shi**<br>**Nagano, 392-8502 (JP)** |
| (30) Priority: **29.11.2013 JP 2013247767** | (74) Representative: **Hoffmann Eitle**<br>**Patent- und Rechtsanwälte PartmbB**<br>**Arabellastraße 30**<br>**81925 München (DE)** |
| (71) Applicant: **Seiko Epson Corporation**<br>**Shinjuku-ku**<br>**Tokyo (JP)** | |

(54) **Ultrasonic transducer device, ultrasonic measurement apparatus, and ultrasonic imaging apparatus**

(57)    An ultrasonic transducer device includes a substrate (220) in which a first opening (10a) and a second opening (10b) are provided, a first ultrasonic transducer element that is formed on the substrate (220) in correspondence with the first opening (10a), and a second ultrasonic transducer element that is formed on the substrate (220) in correspondence with the second opening (10b). The first opening (10a) has a first edge portion (EDA) on a first direction side and a second edge portion (EDB) on a second direction side, the first direction corresponding to a scan direction and the second direction being in the opposite direction to the first direction. Also, the first ultrasonic transducer element includes a first vibrating film (70a) that blocks the first opening (10a), and a first piezoelectric layer (60a) that is provided on the first vibrating film (70a) so as to cover the first edge portion (EDA) of the first opening (10a) in plan view from a thickness direction of the substrate (220).

FIG. 1

EP 2 883 623 A2

**Description**

BACKGROUND

1. Technical Field

The present invention relates to an ultrasonic transducer device, an ultrasonic measurement apparatus, an ultrasonic imaging apparatus, and the like.

2. Related Art

Imaging apparatuses that use ultrasonic waves transmit an ultrasonic beam to a subject, receive an ultrasonic echo reflected back from the subject, and constitute an image from a reception signal thereof. With linear scanning, for example, one ultrasonic beam constitutes one pixel line (scan line). Also, the subject is scanned by moving the emission position of the ultrasonic beam, and the plurality of pixel lines thus obtained constitute one image.

An echo is only reflected back from the true emission direction of the ultrasonic beam if the ultrasonic beam is, ideally, a very narrow beam, thus allowing an image having a high lateral resolution to be obtained. However, since an ultrasonic beam in reality has a certain amount of spread, there is a problem in that lateral resolution decreases. Also, in the case where the ultrasonic beam has side lobes, there is a problem in that artifacts are displayed in the image (phenomenon in which virtual images that do not actually exist are displayed), and hinder diagnosis.

For example, JP-A-2012-523920 discloses, as a technique for improving lateral resolution, disposing two outer arrays at an incline to a central array, and processing the reception signals of the three arrays. However, since the incline changes in units of arrays with this technique, an improvement in lateral resolution in regions near the arrays cannot be anticipated.

SUMMARY

An ultrasonic transducer device, an ultrasonic measurement apparatus and an ultrasonic imaging apparatus that enable an improvement in lateral resolution or a reduction in artifacts are desired.

An aspect of the invention relates to an ultrasonic transducer device including a substrate in which a first opening and a second opening are provided, a first ultrasonic transducer element that is formed on the substrate in correspondence with the first opening, and a second ultrasonic transducer element that is formed on the substrate in correspondence with the second opening. The first opening has a first edge portion on a first direction side and a second edge portion on a second direction side, the first direction corresponding to a scan direction and the second direction being in the opposite direction to the first direction. Also, the first ultrasonic transducer element includes a first vibrating film that blocks the first opening, and a first piezoelectric layer that is provided on the first vibrating film so as to cover the first edge portion of the first opening in plan view from a thickness direction of the substrate.

According to the above aspect of the invention, the first piezoelectric layer is provided on the first vibrating film so as to cover the first edge portion, out of the first and second edge portions of the first opening, in plan view from the thickness direction of the substrate. By using such an ultrasonic transducer element, an improvement in lateral resolution or a reduction in artifacts becomes possible.

In the above aspect of the invention, the second ultrasonic transducer element may include a second vibrating film that blocks the second opening, and a second piezoelectric layer that is provided on the second vibrating film without overlapping with either a third edge portion on the first direction side or a fourth edge portion on the second direction side of the second opening in the plan view.

By thus providing the second piezoelectric layer so as to not overlap with either the third edge portion or the fourth edge portion in plan view from the thickness direction of the substrate, an ultrasonic transducer element having a different directivity from the first ultrasonic transducer element can be provided.

In the above aspect of the invention, the first ultrasonic transducer element may receive an ultrasonic wave with a directivity that is in a direction inclined to the first direction side relative to a reference direction, and the second ultrasonic transducer element may receive an ultrasonic wave with a directivity that is in the reference direction.

By thus receiving ultrasonic waves with different directivities using the first and second ultrasonic transducer elements, correction processing discussed later becomes possible, and lateral resolution can be improved or artifacts can be reduced by this correction processing.

In the above aspect of the invention, the first vibrating film and the second vibrating film may be formed in a same plane.

By adopting the above configuration, first and second ultrasonic transducer elements having different directivities can be formed on first and second vibrating films that are on the same plane, simply by shifting the formation position of the first and second piezoelectric layers relative to the first and second openings. The manufacturing process for ultrasonic transducer devices can thereby be simplified, compared with the case where directivities are provided by inclining the element formation surface, for example.

In the above aspect of the invention, the ultrasonic transducer device may include a third ultrasonic transducer element that is formed on the substrate in correspondence with a third opening that is provided in the substrate. Also, the third ultrasonic transducer element may include a third vibrating film that blocks the third opening, and a third piezoelectric layer that is provided on the third vibrating film so as to cover, out of a fifth edge portion on the first direction side and a sixth edge portion on the second direction side of the third opening, the sixth edge portion in the plan view.

By thus providing the third piezoelectric layer so as to cover the sixth edge portion, out of the fifth and sixth edge portions, in plan view from the thickness direction of the substrate, an ultrasonic transducer element having a different directivity from the first and second ultrasonic transducer elements can be provided.

In the above aspect of the invention, the first ultrasonic transducer element may receive an ultrasonic wave with a directivity that is in a direction inclined to the first direction side relative to the reference direction, and the third ultrasonic transducer element may receive an ultrasonic wave with a directivity that is in a direction inclined to the second direction side relative to the reference direction.

By adopting the above configuration, ultrasonic waves can be received with directivities that are inclined in a first direction and a second direction relative to a reference direction. It thereby becomes possible to perform correction processing discussed later on both sides of the reference direction, and the lateral resolution can be improved or artifacts can be reduced on both sides of the reference direction.

In the above aspect of the invention, the first vibrating film and the third vibrating film may be formed in a same plane.

By adopting the above configuration, first and third ultrasonic transducer elements having different directivities can be formed on first and third vibrating films that are on the same plane, simply by shifting the formation position of the first and third piezoelectric layers relative to the first and third openings. The manufacturing process for ultrasonic transducer devices can thereby be simplified, compared with the case where directivities are provided by inclining the element formation surface, for example.

In the above aspect of the invention, an area of the first piezoelectric layer over the first opening may be greater than an area of the first piezoelectric layer over the substrate in the plan view.

Because the element pitch in the ultrasonic transducer is set according to the frequency of the ultrasonic waves, for example, it is desirable to be able to set the element pitch freely. In this regard, in the above aspect of the invention, the area of the first piezoelectric layer that rides up over the substrate can be reduced, thus enabling the pitch between adjacent elements to be narrowed, and making it possible to realize a desired element pitch while providing the elements with directivity.

Another aspect of the invention relates to an ultrasonic transducer device including a first ultrasonic transducer element that has directivity in a first directivity direction that differs from a reference direction, and performs ultrasonic wave reception, and a second ultrasonic transducer element that has directivity of a second directivity direction that is the reference direction, and performs ultrasonic wave transmission or ultrasonic wave transmission and reception.

In the other aspect of the invention, the ultrasonic transducer device may include a third ultrasonic transducer element that has directivity of a third directivity direction that differs from the reference direction, and performs ultrasonic wave reception. Also, the reference direction may be a direction between the first directivity direction and the third directivity direction.

Stress on the vibrating film at the edge portions tends to increase when the piezoelectric layer overlaps with the edge portions, but because the vibrating film does not vibrate as much at the time of reception as at the time of transmission, the amount of stress on the vibrating film at the edge portions is also small. According to the other aspect of the invention, ultrasonic waves are transmitted by the second ultrasonic transducer element in which the piezoelectric layer does not overlap with an edge portion of the opening, and ultrasonic waves are received by the first and third ultrasonic transducer elements in which the piezoelectric layer overlaps with an edge portion of the opening. Information having different directivities can thereby be acquired, while suppressing element failure.

Yet another aspect of the invention relates to an ultrasonic measurement apparatus including any of the ultrasonic transducer devices described above, and a processing unit that generates an ultrasonic image based on a first reception signal received by the first ultrasonic transducer element.

Yet another aspect of the invention relates to an ultrasonic measurement apparatus including any of the ultrasonic transducer devices described above, and a processing unit that performs processing for correcting second reception information which is a second reception signal received by the second ultrasonic transducer element or second reception data that is obtained from the second reception signal, using first reception information which is a first reception signal received by the first ultrasonic transducer element or first reception data that is obtained from the first reception signal.

Yet another aspect of the invention relates to an ultrasonic measurement apparatus including any of the ultrasonic transducer devices described above, a processing unit that generates an ultrasonic image based on a first reception signal received by the first ultrasonic transducer element, and a display unit that displays the ultrasonic image.

BRIEF DESCRIPTION OF THE DRAWINGS

The invention will be described with reference to the accompanying drawings, wherein like numbers reference like elements.

Fig. 1 shows an exemplary configuration of a first ultrasonic transducer element.
Fig. 2 shows an exemplary configuration of a second ultrasonic transducer element.
Fig. 3 shows an exemplary configuration of a third ultrasonic transducer element.
Figs. 4A to 4C illustrate conditions for measuring reception directivity.
Figs. 5A and 5B illustrate results of measuring reception directivity.
Figs. 6A to 6F illustrate principles under which directivity occurs.
Figs. 7A and 7B illustrate linear scanning.
Fig. 8 shows a comparative example of an embodiment.
Fig. 9 shows exemplary configurations of an ultrasonic measurement apparatus and an ultrasonic imaging apparatus of an embodiment.
Fig. 10A shows exemplary correction processing according to a first technique, and Fig. 10B shows exemplary correction processing according to a variation of the first technique.
Fig. 11 shows exemplary correction processing according to a second technique.
Fig. 12 shows an exemplary configuration of an ultrasonic transducer device.
Fig. 13 shows an exemplary configuration of channels.
Figs. 14A and 14B show specific exemplary configurations of an ultrasonic imaging apparatus, and Fig. 14C shows a specific exemplary configuration of an ultrasonic probe.

DESCRIPTION OF EXEMPLARY EMBODIMENTS

Hereinafter, preferred embodiments of the invention will be described in detail. Note that the embodiments described below are not intended to unduly limit the scope of the invention as defined in the claims, and not all combinations of the features described in the embodiments are essential to means for solving the problems addressed by the invention.

1. Ultrasonic Transducer Element

In order to solve the abovementioned problems, in the present embodiment, first to third ultrasonic transducer elements are provided with different directivities. The configuration of the first to third ultrasonic transducer elements will be described below.

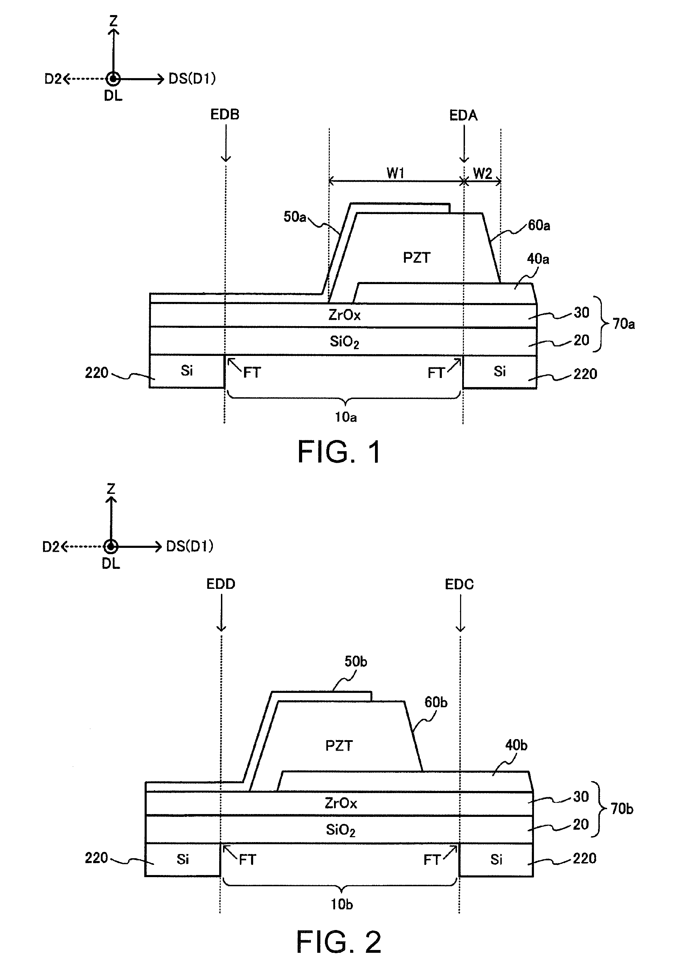

Fig. 1 shows an exemplary configuration of the first ultrasonic transducer element of the present embodiment. A first opening 10a is provided in a substrate 220 of an ultrasonic transducer device. The first ultrasonic transducer element is formed on the substrate 220 in correspondence with the first opening 10a.
The first ultrasonic transducer element includes a first vibrating film 70a that blocks the first opening 10a, and a first piezoelectric layer 60a that is provided on the first vibrating film 70a. The first piezoelectric layer 60a is provided on the first vibrating film 70a so as to cover a first edge portion EDA, out of first and second edge portions EDA and EDB of the first opening 10a, in plan view from a thickness direction Z of the substrate 220. The first edge portion EDA is the edge portion on a first direction D1 side, and the second edge portion EDB is the edge portion on a second direction D2 side, the second direction D2 being in the opposite direction to the first direction D1. The first direction D1 corresponds to a scan direction DS on the substrate 220.
Here, the edge portions are the boundary between the first opening 10a and the substrate 220. More specifically, the edge portions form a boundary FT between the first opening 10a and the substrate 220 in a plane touching the substrate 220 and the first vibrating film 70a. The first edge portion EDA and the second edge portion EDB form the boundary FT in a cross-section of a plane that is formed by the scan direction DS and the depth direction Z.
By thus shifting the first piezoelectric layer 60a to the first direction D1 side from the center of the first opening 10a so that the first piezoelectric layer 60a lays over the shoulder (boundary FT) of the first opening 10a, a first directivity inclined to the side on which the first piezoelectric layer 60a lays over the shoulder can be provided. Note that the reason for directivity occurring will be discussed in detail later.
As a comparative example of the present embodiment, it is conceivable to change the directivity by changing the incline in units of arrays, as in JP-A-2012-523920 mentioned above. However, since a subject in close proximity to the arrays is only observed by the array that is nearby, there is a problem in that the lateral resolution is not improved in close proximity to the arrays.

In this regard, in the present embodiment, it is possible to change the directivity in units of ultrasonic transducer elements or in units of ultrasonic transducer element columns, rather than in units of arrays. Thus, even in regions in proximity to an ultrasonic transducer element array, reception signals having different directivities can be obtained and lateral resolution can be improved.

Fig. 2 shows an exemplary configuration of the second ultrasonic transducer element of the present embodiment. A second opening 10b is provided in the substrate 220. The second ultrasonic transducer element is formed on the substrate 220 in correspondence with the second opening 10b.

The second ultrasonic transducer element includes a second vibrating film 70b that blocks the second opening 10b and a second piezoelectric layer 60b that is provided on the second vibrating film 70b. The second piezoelectric layer 60b is provided on the second vibrating film 70b so as to not overlap with either a third edge portion EDC or a fourth edge portion EDD of the second opening 10b, in plan view from the thickness direction Z of the substrate 220. That is, the second piezoelectric layer 60b is smaller in width than the second opening 10b in the scan direction DS. The third edge portion EDC is the edge portion on the first direction D1 side, and the fourth edge portion EDD is the edge portion on the second direction D2 side.

By thus providing the second piezoelectric layer 60b in the center of the second opening 10b and not laying the second piezoelectric layer 60b over the shoulder (boundary FT) of the second opening 10b, a second directivity serving as a reference direction that is not inclined to either the third edge portion EDC side or the fourth edge portion EDD side can be provided. Note that the second piezoelectric layer 60b does not necessarily need to be provided in the center of the second opening 10b, and need only not overlap with the edge portions of the second opening 10b.

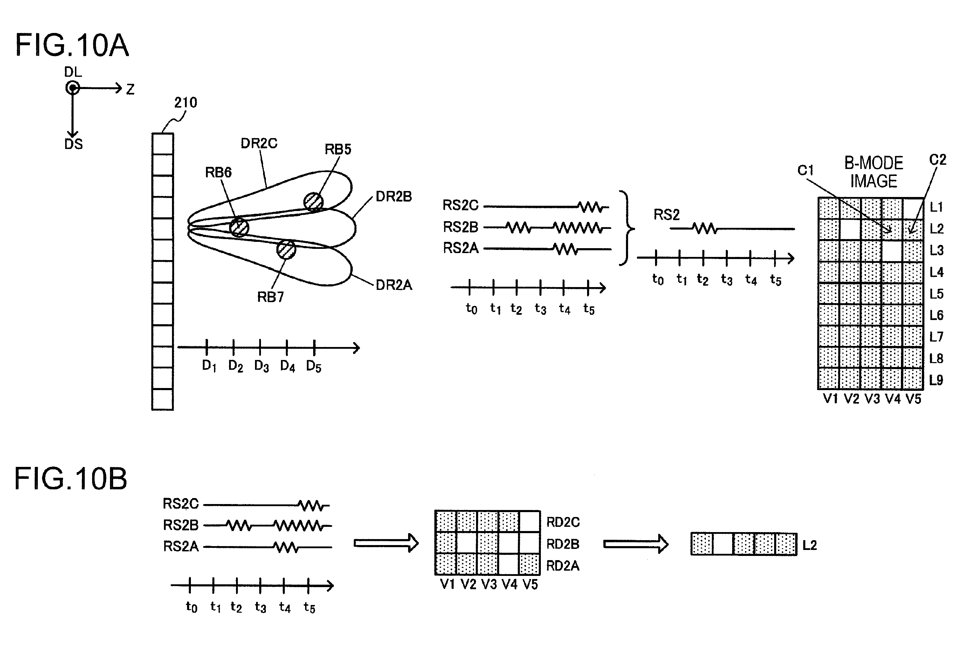

The first ultrasonic transducer element receives ultrasonic waves with the first directivity (DR2A in Fig. 10A) which is in a direction inclined to the first direction D1 side relative to the reference direction. On the other hand, the second ultrasonic transducer element receives ultrasonic waves with the second directivity (DR2B in Fig. 10A) which is the reference direction.

Here, the reference direction is the thickness direction Z of the substrate 220, and intersects the scan direction DS and the slice direction DL orthogonally (including approximately orthogonally). That is, the first directivity which is inclined to the first direction D1 side relative to the reference direction is a direction arrived at by rotating the thickness direction Z of the substrate 220 clockwise as seen from the slice direction DL side.

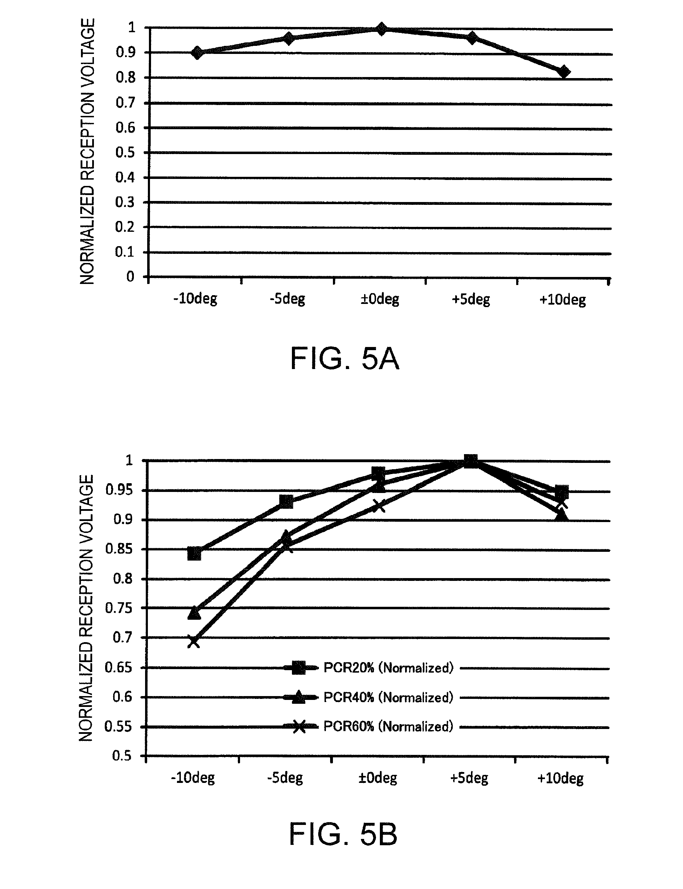

Also, directivity is characterized by having a receiving sensitivity that differs according to the direction of incidence of the ultrasonic waves. That is, as shown in Figs. 5A and 5B, with ultrasonic transducer elements having different directivities, the distributions of receiving sensitivities relative to the direction of incidence of the ultrasonic waves differ. For example, the second directivity corresponds to Fig. 5A, and has a maximum receiving sensitivity in the frontal direction. On the other hand, the first directivity corresponds to Fig. 5B, and has a maximum receiving sensitivity in a direction to the right side of the frontal direction.

By receiving ultrasonic echoes with ultrasonic transducer elements thus having different directivities, it becomes possible to perform correction processing using reception signals thereof, and to improve lateral resolution or reduce artifacts caused by side lobes. For example, with a first correction technique discussed later using Fig. 10A, the echos (timing $t_4$ of RS2B) from a reflector RB7 that exists between two directivities can be suppressed based on the reception signals (RS2A and RS2B of the two directivities. Because the echo from the reflector RB7 that is not in front of an ultrasonic beam BM2 can thereby be suppressed, an ultrasonic image having a high lateral resolution or reduced artifacts can be generated.

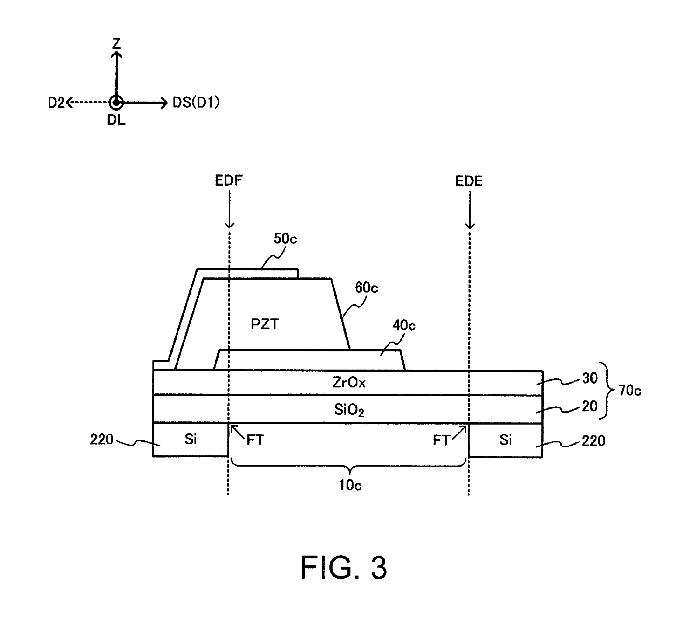

Fig. 3 shows an exemplary configuration of the third ultrasonic transducer element of the present embodiment. A third opening 10c is provided in the substrate 220. The third ultrasonic transducer element is formed on the substrate 220 in correspondence with the third opening 10c.

The third ultrasonic transducer element includes a third vibrating film 70c that blocks the third opening 10c, and a third piezoelectric layer 60c that is provided on the third vibrating film 70c. The third piezoelectric layer 60c is provided on the third vibrating film 70c so as to cover a sixth edge portion EDF, out of fifth and sixth edge portions EDE and EDF of the third opening 10c, in plan view from the thickness direction Z of the substrate 220. The fifth edge portion EDE is the edge portion on the first direction D1 side, and the sixth edge portion EDF is the edge portion on the second direction D2 side.

By thus shifting the third piezoelectric layer 60c to the second direction D2 side from the center of the third opening 10c so that the third piezoelectric layer 60c lays over the shoulder (boundary FT) of the third opening 10c, a third directivity inclined to the side on which the third piezoelectric layer 60c lays over the shoulder can be provided.

The third ultrasonic transducer element receives ultrasonic waves with the third directivity which is in a direction inclined to the second direction D2 side from the reference direction (thickness direction Z of the substrate 220).

Here, the direction inclined to the second direction D2 side relative to the reference direction is arrived at by rotating the thickness direction Z of the substrate 220 counterclockwise as seen from the slice direction DL side. The rotation angle is the same (including approximately the same) as the first directivity, for example.

By adopting the above configuration, ultrasonic echoes can be received with the third directivity which is on the opposite side to the first directivity across the reference direction. By performing correction processing using these reception signals, correction processing such as will be discussed later using Fig. 10A, for example, can be performed on both sides of the reference direction, making it possible to improve lateral resolution or reduce artifacts caused by side lobes on both sides of the reference direction.

The first to third vibrating films 70a to 70c of the first to third ultrasonic transducer elements are formed in the same (including approximately the same) plane. The same plane is the plane of the substrate 220 and is the plane that is formed by the scan direction DS and the slice direction DL. As will be discussed later, the first to third vibrating films 70a to 70c are constituted by a common $SiO_2$ film 20 and a common $ZrOx$ film 30 laminated on the substrate 220, for example. Of these common vibrating films, the vibrating films in the formation region of the respective elements are the first to third vibrating films 70a to 70c.

As a comparative example, a technique for providing transmission directivity or reception directivity by inclining the element formation surface, for example, is conceivable. However, in order to create a plurality of directivity directions, the incline of the element formation surface needs to be changed accordingly. If applied to the ultrasonic transducer elements of the present embodiment, a plurality of vibrating films having different inclines need to be formed, complicating the element array manufacturing process.

In this regard, according to the present embodiment, the directivity can be changed simply by shifting the formation position of the first to third piezoelectric layers 60a to 60c relative to the first to third openings 10a to 10c, thus enabling ultrasonic transducer elements having different directivities to be formed in the same plane. The element array manufacturing process can thereby be simplified. For example, the formation position can be changed by changing the mask in the process of forming the first to third piezoelectric layers 60a to 60c, thus enabling an element array in which directivities are mixed to be manufactured with a similar process to an element array having a single directivity.

Next, a configuration common to the first to third ultrasonic transducer elements will be described, taking the first ultrasonic transducer element shown in Fig. 1 as an example.

The first ultrasonic transducer element includes the first vibrating film 70a (membrane), a first electrode layer 40a (lower electrode layer, first electrode), the first piezoelectric layer 60a (piezoelectric film, piezoelectric element part) and a second electrode layer 50a (upper electrode layer, second electrode).

The first ultrasonic transducer element is formed on the substrate 220 on the depth direction Z side. The depth direction Z is the direction in which ultrasonic waves are transmitted, and is perpendicular to the plane of the substrate 220. The substrate 220 is a Si (silicon) substrate, for example.

The first opening 10a is formed by etching from the back surface side of the substrate 220 on which the elements are not formed, using reactive ion etching (RIE) or the like. The resonance frequency of the ultrasonic waves is determined by the size of the first vibrating film 70a (diaphragm) which can vibrate due to the formation of this first opening 10a.

The first vibrating film 70a is provided so as to block the first opening 10a using a two-layer structure consisting of the $SiO_2$ film 20 and the $ZrOx$ film 30. This first vibrating film 70a supports the first piezoelectric layer 60a, the first electrode layer 40a and the second electrode layer 50a, and is able to vibrate in accordance with the expansion and contraction of the first piezoelectric layer 60a and produce ultrasonic waves.

The first electrode layer 40a is formed on the upper layer of the first vibrating film 70a with a metal thin film, for example. A metal thin film is a thin film formed by laminating a metal such as platinum (Pt) or iridium (Ir), for example. The first electrode layer 40a may be formed to extend outside the element formation region, and wiring such as signal electrode lines may be formed.

The first piezoelectric layer 60a is formed of a PZT (lead zirconate titanate) thin film, for example, and is provided so as to cover at least a portion of the first electrode layer 40a. Note that the material of the first piezoelectric layer 60a is not limited to PZT, and lead titanate ($PbTiO_3$), lead zirconate ($PbZrO_3$), lanthanum-modified lead titanate (($Pb, La$)($TiO_3$)) or the like may be used, for example.

The first piezoelectric layer 60a expands and contracts in the in-plane direction as a result of a voltage being applied between the first electrode layer 40a and the second electrode layer 50a. The ultrasonic transducer element uses a monomorph (unimorph) structure formed by adhering a thin piezoelectric element (first piezoelectric layer 60a) to a metal plate (first vibrating film 70a), and warping occurs because the dimensions of the first vibrating film 70a remain unchanged when the first piezoelectric layer 60a adhered thereto expands and contracts in-plane. Applying an AC current to the first piezoelectric layer 60a causes the first vibrating film 70a to vibrate in the film thickness direction, and ultrasonic waves are radiated as a result of this vibration of the first vibrating film 70a.

The second electrode layer 50a is formed by a metal thin film, for example, and is provided so as to cover at least a portion of the first piezoelectric layer 60a. The metal thin film is a thin film formed using a metal such as iridium (Ir), for example. The second electrode layer 50a may be formed to extend outside the element formation region, and wiring such as common electrode lines may be formed.

Constituting an ultrasonic transducer element with the first piezoelectric layer 60a as described above enables the element to be miniaturized compared with a bulk ultrasonic transducer element. The element pitch can thereby be reduced, enabling the occurrence of grating lobes to be suppressed. Also, the ultrasonic transducer element can be driven with a small voltage amplitude compared with a bulk ultrasonic transducer element, enabling the drive circuit to be constituted by circuit elements having a low breakdown voltage.

As shown in Fig. 1, a width W1 of the portion of the first piezoelectric layer 60a that overlaps with the first opening 10a is greater than a width W2 of the portion of the first piezoelectric layer 60a that overlaps with the substrate 220. The width W1 is the distance in the second direction D2 from the first edge portion EDA to the end of the first piezoelectric layer 60a, and the width W2 is the distance in the first direction D1 from the first edge portion EDA to the end of the first piezoelectric layer 60a. In plan view as seen from the thickness direction Z of the substrate 220, the area of the first piezoelectric layer 60a over the first opening 10a is greater than the area of the first piezoelectric layer 60a over the substrate 220.

Because the element pitch in an ultrasonic transducer element array is set according to the frequency of the ultrasonic waves, and the element pitch affects the performance of grating lobes and the like, it is desirable to be able to set the element pitch freely. In this regard, in the present embodiment, it is possible to narrow the pitch between adjacent elements compared with the case where the width W2 of the portion that rides up over the substrate 220 is large, and it becomes possible to realize a desired element pitch while providing the elements with directivity.

2. The reception directivity of ultrasonic transducer elements will now be described, followed by description of the result of measuring the reception directivity of ultrasonic transducer elements.

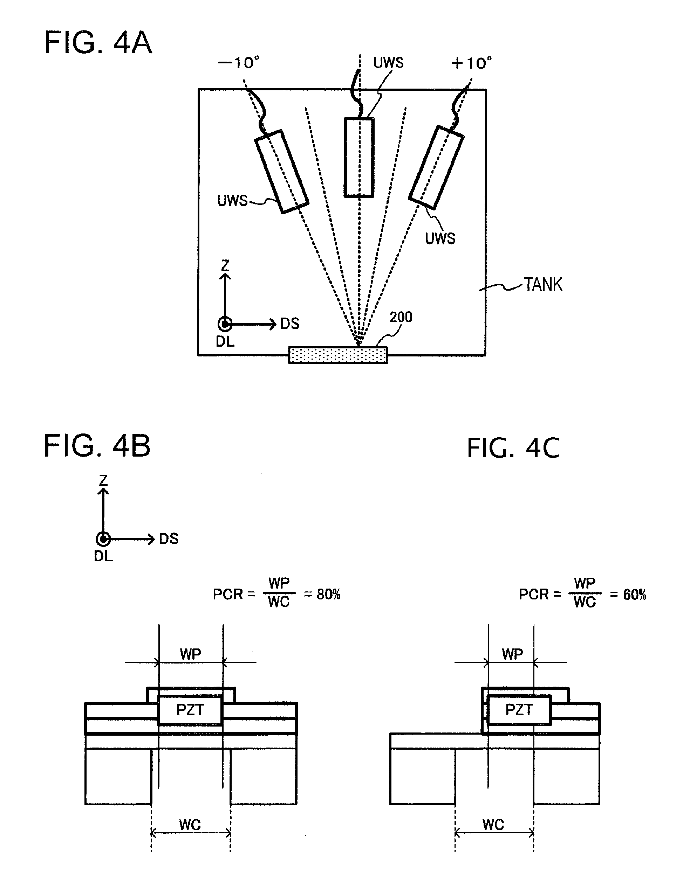

Figs. 4A and 4B show diagrams illustrating measurement conditions. As shown in Fig. 4A, an ultrasonic transducer device 200 is installed in the wall of a tank, as seen when the tank is viewed from above. Ultrasonic wave sources UWS are installed on the depth direction Z side, and the ultrasonic transducer device 200 is irradiated with ultrasonic waves. The angles of incidence of the ultrasonic waves are from +10 degrees to -10 degrees with the depth direction Z as 0 degrees. Reception is performed with one row of ultrasonic transducer elements (or one ultrasonic transducer element).

As shown in Fig. 4B, the ratio of a width WC of the opening and a width WP of the piezoelectric layer that overlaps with the opening is defined as PCR = WP/WC. The widths WC and WP are the widths of the opening and the piezoelectric layer in the scan direction DS when seen from the thickness direction Z of the substrate.

Fig. 5A shows the result of measuring the reception directivity of an ultrasonic transducer element in which the piezoelectric layer is not overlapped with the substrate (Fig. 2). The vertical axis is the reception voltage normalized with the maximum value. It can be seen that the reception voltages are distributed substantially symmetrically about the angle of incidence of 0 degrees with a maximum at an angle of incidence of 0 degrees, and have directivity in the thickness direction Z of the substrate.

Fig. 5B shows the result of measuring the reception directivity of an ultrasonic transducer element (Fig. 1) in which the piezoelectric layer is overlapped with the substrate. It can be seen that the reception voltages are distributed with a maximum value at an angle of incidence of +5 degrees, and have directivity in a direction inclined to the scan direction DS side from the thickness direction Z of the substrate. While a change in PCR has little effect on directivity, the directivity peak does become more pointed and directivity is stronger if the PCR is large (PCR = 60%).

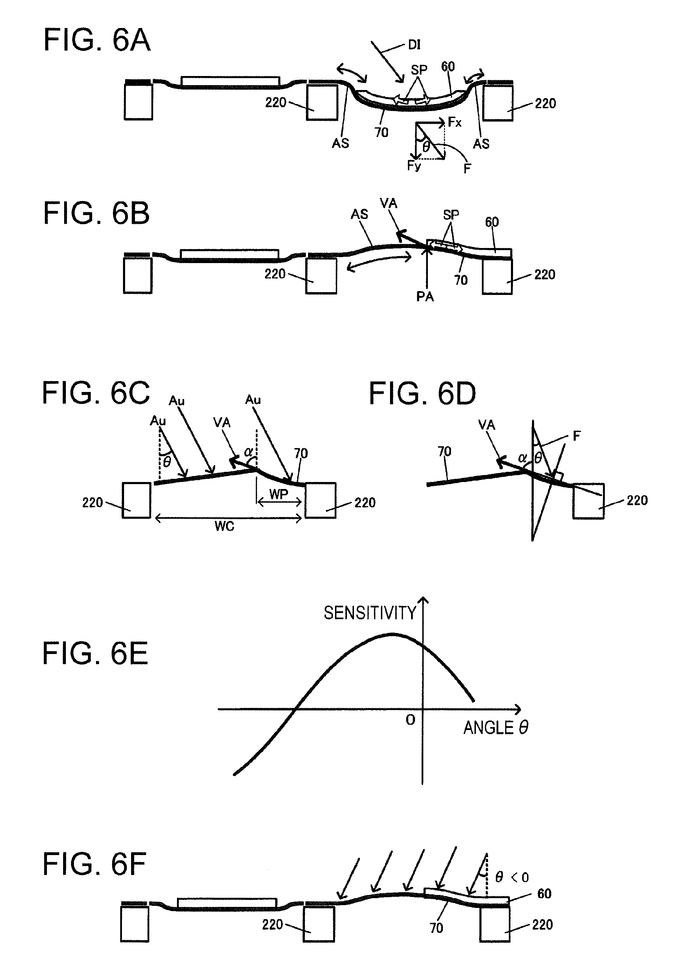

Next, the principles under which directivity occurs will be described using Figs. 6A to 6F. Note that, here, the opposite direction to the depth direction Z will be referred to as the "vertical direction", and the scan direction DS will be referred to as the "horizontal direction".

As shown in Fig. 6A, the vibrating film 70 bends and the piezoelectric layer 60 is stretched sideways when ultrasonic waves are incident on the element. Deformation SP of the piezoelectric layer 60 is converted into reception voltage by the piezoelectric effect. This is a basic principle of reception.

Assume that ultrasonic waves are incident on an element in which in the piezoelectric layer 60 does not lay over the substrate 220, from an oblique direction DI. In this case, a force F acts on the vibrating film 70 in the direction DI. The force F can be broken down into a horizontal force $Fx = F\sin\theta$ and a vertical force $Fy = F\cos\theta$, where $\theta$ is the angle of incidence. When the vibrating film 70 is bent by this force F, arm portions AS that over which the piezoelectric layer 60 does not lay tend to stretch more than the portion over which the piezoelectric layer 60 does lay. Thus, the horizontal force Fx is canceled by the stretching of the arm portions AS on both sides, resulting in deformation due to the force Fx not occur in the piezoelectric layer 60, and only the vertical force Fy being converted into reception voltage. Because force $Fy = F\cos\theta$ is maximized at $\theta$ = 0 degrees and becomes smaller as the angle increases, the element has directivity in the vertical direction.

As shown in Fig. 6B, assume that ultrasonic waves are incident on an element in which the piezoelectric layer 60 lays over the substrate 220, from the oblique direction DI. In this case, since the arm portion AS only exits to one side of the piezoelectric layer 60, the horizontal force Fx is not canceled, and the dependency of the reception voltage on the angle of incidence $\theta$ is revealed.

Specifically, since the arm portion AS of the vibrating film 70 over which the piezoelectric layer 60 does not lay is sufficiently flexible to offset curvature, the vibrating film 70 can be schematically represented as shown in Fig. 6C.

Consider a state where an ultrasonic wave having an amplitude Au is uniformly incident on the entire vibrating film 70 at an angle of incidence $\theta$.

As shown in Fig. 6B, the force that acts on a point PA on the edge of the piezoelectric layer 60 due to the vibration of the vibrating film 70 is given as a vector VA. The direction of the vector VA is equal to the direction of the tangent at the edge of the curved piezoelectric layer 60. The deformation SP that occurs within the piezoelectric layer 60 is in a vertical direction orthogonal to the vector VA (Fig. 6D), and is proportional to the size of the vector VA in the direction of the vector VA.

Stress $\sigma_{PZT}$ that occurs on the piezoelectric layer 60 in the vertical direction is approximately given by the following equation (1), where $\alpha$ is the angle that is formed by the direction of the vector VA and the perpendicular.

$$\sigma_{PZT} = Au \cdot \sin(90° - \alpha + \theta) \qquad (1)$$

Also, stress $\sigma_{arm}$ on the arm portion AS in the direction of the vector VA is approximately given by the following equation (2).

$$\sigma_{arm} = Au \cdot \cos(90° - \alpha + \theta) \qquad (2)$$

Electric charge $C_{PZT}$ that occurs in the piezoelectric layer 60 is given by the following equation (3), where $g_{31}$ is the piezoelectric constant with respect to the deformation of the piezoelectric layer 60 that occurs in the vertical direction due to the stress $\sigma_{PZT}$, and $g_{33}$ is the piezoelectric constant with respect to the deformation of the piezoelectric layer 60 that occurs in the direction of the vector VA due to the stress $\sigma_{arm}$ on the arm portion AS.

$$\begin{aligned} C_{PZT} &= g_{31} \cdot \sigma_{PZT} \cdot WP + g_{33} \cdot \sigma_{arm} \cdot WC \\ &= g_{31} \cdot WP \cdot Au \cdot \sin(90° - \alpha + \theta) + \\ &\quad g_{33} \cdot WC \cdot Au \cdot \cos(90° - \alpha + \theta) \qquad (3) \end{aligned}$$

As shown in Fig. 6E, when the above equation (3) is shown as the sensitivity characteristics, sensitivity is maximized in the case where the angle of incidence $\theta$ is negative. That is, as shown in Fig. 6F, sensitivity peaks when the ultrasonic wave is incident from the side on which the piezoelectric layer 60 overlaps with the substrate 220, and the reception directivity differs from the case where the piezoelectric layer 60 does not overlap with the substrate 220.

3. Linear Scanning

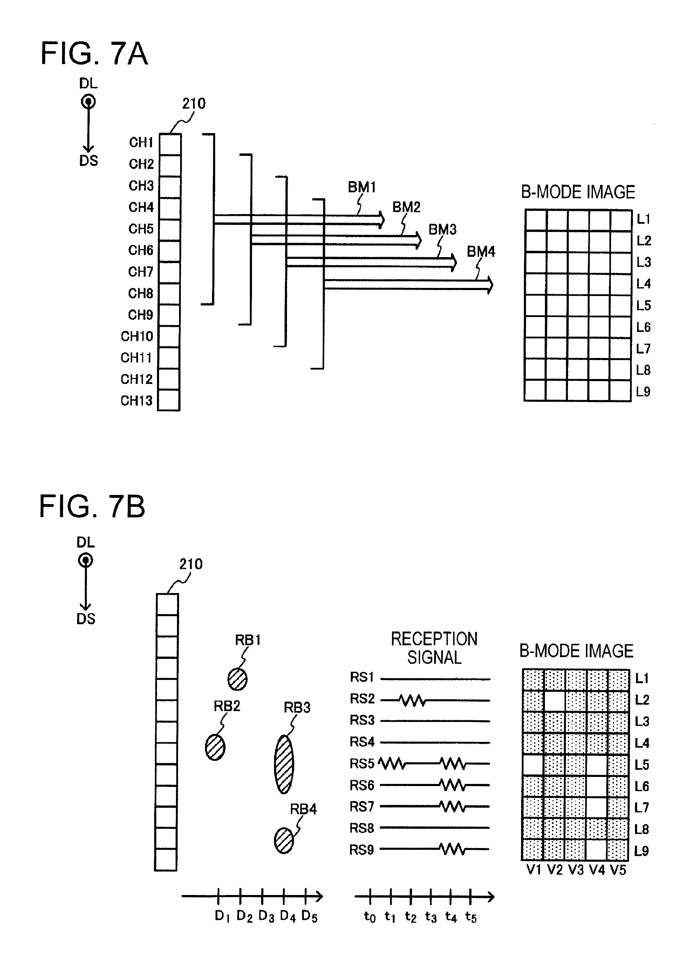

Next, a basic technique of correction processing that is performed using reception signals obtained by the first to third ultrasonic transducer elements will be described. First, linear scanning will be described using the schematic diagrams shown in Figs. 7A and 7B.

Fig. 7A is a diagram of an ultrasonic transducer element array 210 as seen from the slice direction DL side. Channels CH1 to CH13 are arrayed in the scan direction DS. Taking the case where one ultrasonic beam is transmitted with eight channels as an example, first the channels CH1 to CH8 transmit an ultrasonic beam BM1. The channels CH1 to CH8 receive the reflected wave of the ultrasonic beam, and a pixel line L1 (scan line) of a B-mode image is generated from a reception signal thereof. This processing is repeated with channels CH2 to CH9, CH3 to CH10, and so on to generate pixel lines L2, L3, and so on of the B-mode image. Because scanning is performed while shifting one channel at a time, one pixel line corresponds to the width of one channel.

Fig. 7B shows an example of reception signals and a B-mode image in the case where there are reflectors. The reception signals RS1 to RS9 are obtained as a result of the ultrasonic beams BM1 to BM9. Fig. 7B shows the change in the timing of the reception signals, with the reception of echoes in the reception signals starting at time $t_0$. The reflectors RB1 to RB4 are portions on the subject that have different acoustic impedances from the surrounding region, and reflect ultrasonic waves. The echoes from these reflectors RB1 to RB4 appear as amplitudes of the reception signals RS1 to RS9. When the distances from the ultrasonic transducer element array 210 to the reflectors RB1 to RB4 are represented as $D_1$ to $D_5$ ($D_1 < D_2 < D_3 < D_4 < D_5$), the echoes from the distances $D_1$ to $D_5$ appear at times $t_1$ to $t_5$ ($t_0 < t_1 < t_2 < t_3 < t_4 < t_5$) of the reception signals.

The B-mode image is obtained by converting the amplitudes of the reception signals RS1 to RS9 into luminance values of the pixel lines L1 to L9. Specifically, in the case where pixel positions in the lateral direction on the page are given as V1 to V5, the amplitudes at times $t_1$ to $t_5$ of the reception signals are respectively converted into luminance values of the pixels at the pixel positions V1 to V5. That is, the pixel positions V1 to V5 correspond to the distances $D_1$ to $D_5$ from the ultrasonic transducer element array 210. B-mode images corresponding to the positions of the reflectors RB1 to RB4 are thus obtained by linear scanning.

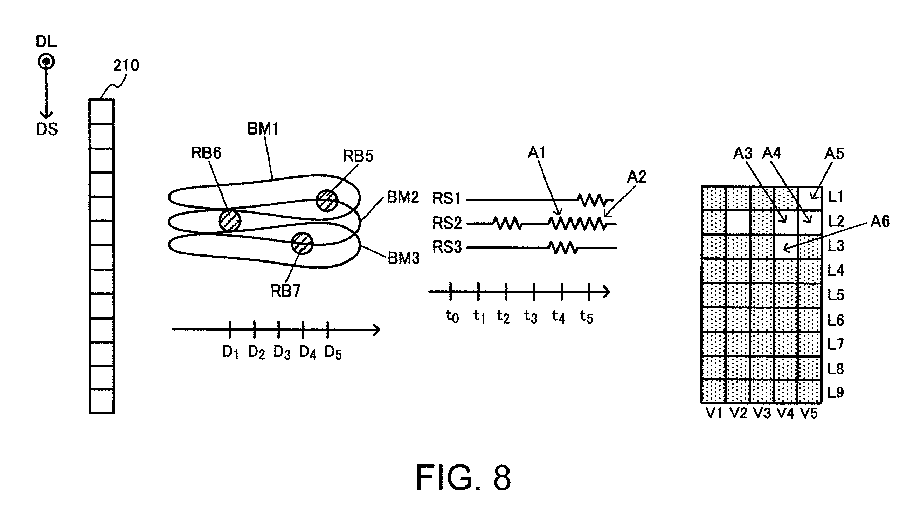

Fig. 8 shows a comparative example of the present embodiment. As shown in Fig. 8, assume that small reflectors RB5 to RB7 are respectively provided within the irradiation ranges of the ultrasonic beams BM1 to BM3. Ideally, when the ultrasonic beams BM1 to BM3 are transmitted, only the echoes from the reflectors RB5 to RB7 are respectively received.

However, in reality, the ultrasonic beams are wide in the scan direction DS, and overlap with adjacent ultrasonic beams in the case where this width is greater than the pitch of the channels. Since the reflectors RB5 and RB7 are in regions where ultrasonic beams overlap, echoes are observed with respect to not only the ultrasonic beams BM1 and BM3 but also the ultrasonic beam BM2, and signals indicated by A1 and A2 are superimposed on the reception signal RS2. These echoes appear as images in the pixels indicated by A3 and A4 on the pixel line L2. Ideally, the images of the reflectors RB5 and RB7 desirably appear in the pixels indicated by A5 and A6, but the images straddle two pixel lines due to the width of the beam. This means that the reflectors look to be larger than they actually are in the scan direction DS. There is thus a problem in that the lateral resolution of the image decreases due to the spread of the beams.

4. Basic Technique of Correction Processing

Correction processing that is performed by an ultrasonic measurement apparatus 100 of the present embodiment and can solve the above problem will now be described. A basic technique will be described here, with a detailed description of the configuration and operations being given later.

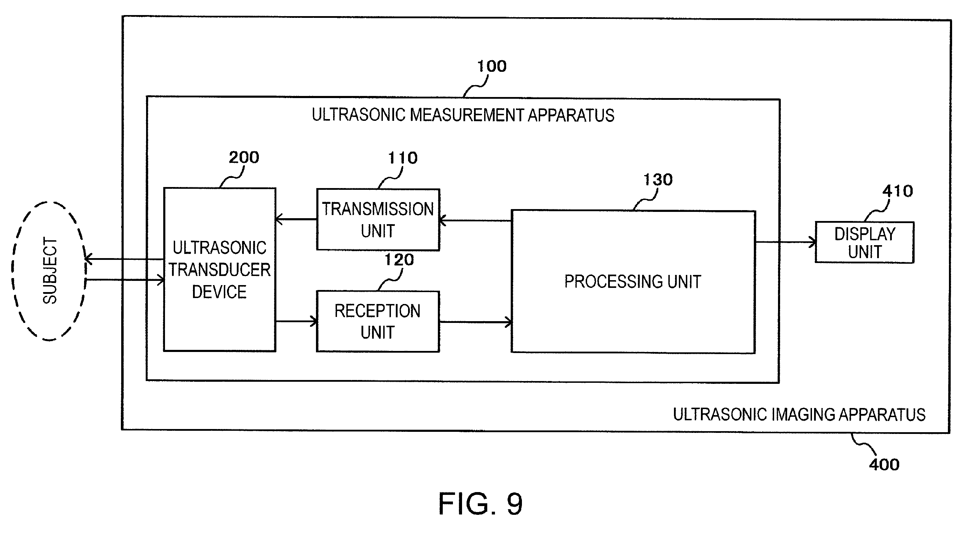

As shown in Fig. 9, the ultrasonic measurement apparatus 100 includes the ultrasonic transducer device 200 and a processing unit 130.

The ultrasonic transducer device 200 has the first ultrasonic transducer element which receives ultrasonic waves with the first directivity and the second ultrasonic transducer element which receives ultrasonic waves with the second directivity.

The processing unit 130 performs correction processing that involves using first reception information to correct second reception information. The first reception information is a first reception signal received by the first ultrasonic transducer element or first reception data that is obtained from the first reception signal. The second reception information is a second reception signal received by the second ultrasonic transducer element or second reception data that is obtained from the second reception signal.

The first reception information and the second reception information are pieces of reception information that are obtained by one transmission of an ultrasonic beam in linear scanning. As shown in Fig. 10A, transmission of an ultrasonic beam is performed by a single directivity (e.g., only frontal) ultrasonic transducer element (ultrasonic beam BM2). Reception of echoes is performed by mixing ultrasonic transducer elements having different directivities (directivities DR2A to DR2C), and results in the acquisition of first reception information and second reception information having different directivities.

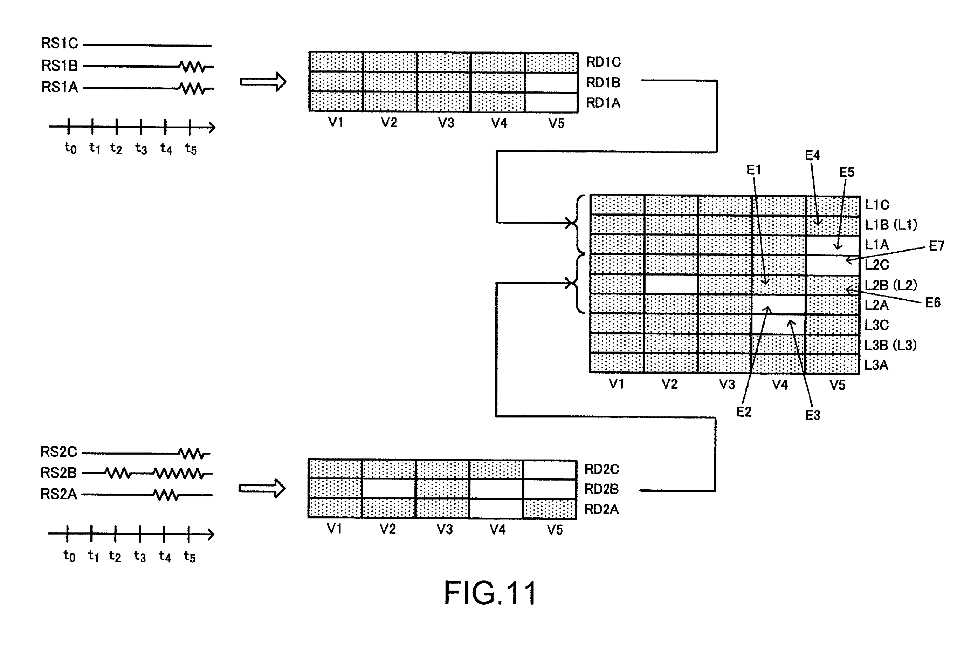

For example, with the first correction technique discussed later using Fig. 10A, by performing processing for correcting the second reception signal RS2B using the first reception signal RS2A, the reception signal RS2 in which unwanted echoes caused by the spread of the beams has been suppressed is obtained, and lateral resolution improves. Also, as will be discussed later using Fig. 10B, the first and second reception signals RS2A and RS2B, which are analog signals, may be converted into digital signals, and correction processing may be performed on the digital second reception data RD2B with the digital first reception data RD2A. Alternatively, in second correction processing discussed later using Fig. 11, by performing correction processing when generating an ultrasonic image using the first reception data RD2A and the second reception data RD2B, an ultrasonic image (pixel lines L2A to L2C) in which unwanted echoes have been suppressed is obtained, and lateral resolution improves.

Also, these techniques are able to reduce artifacts caused by side lobes. Side lobes are phenomena in which the sound pressure peak occurs in a different direction to the main beam, and artifacts occur in the B-mode image due to echoes from the direction of the side lobes. The above techniques are able to reduce the influence of echoes that come from directions other than in front of the beam, and are thus effective in reducing artifacts.

More specifically, with the first correction technique shown in Fig. 10A, the processing unit 130 performs processing for attenuating the amplitude of the second reception signal RS2B at the detection time, in the case where the first reception signal RS2A and the second reception signal RS2B are detected.

The fact that an echo exists in both the first reception signal RS2A and the second reception signal RS2B indicates that the reflector RB7, which reflected this echo, exists in the direction of the first directivity DR2A rather than in front of the ultrasonic beam BM2. By attenuating such an echo, it becomes possible to keep only the echo in front of the beam (reception signal RS2B detected at time $t_2$). By adopting the above configuration, unwanted echoes included in the second reception signal RS2B can be directly suppressed, using the difference in the directivities of the first ultrasonic transducer element and the second ultrasonic transducer element.

In the second correction processing shown in Fig. 11, the processing unit 130 performs correction processing on an ultrasonic image based on the first reception information and the second reception information. That is, the pixel lines L2A and L2B of a B-mode image are generated, based on the first reception signal RS2A and the second reception signal RS2B or the first reception data RD2A and the second reception data RD2B obtained by digitizing these signals. The pixel values of these pixel lines L2A and L2B are corrected at this time.

In the example shown in Fig. 11, the luminance value of the pixel indicated by E1 has been reduced. The image of the reflector RB7 that is indicated by E2 and E3 will thereby exist on the lower side of the pixel line L2A on the page, and will be an image reflecting the actual position of the reflector RB7, compared with the comparative example (A3, A6) shown in Fig. 8. By adopting the above configuration, a B-mode image in which the lateral resolution is improved can be generated using the difference in the directivities of the first ultrasonic transducer element and the second ultrasonic transducer element.

The ultrasonic transducer device 200 shown in Fig. 9 further includes a third ultrasonic transducer element that receives ultrasonic waves with a third directivity. The processing unit 130 performs correction processing on the second reception information using the first reception information and third reception information. The third reception information is a third reception signal received by the third ultrasonic transducer element, or third reception data that is obtained from the third reception signal.

As shown in Fig. 10A, the beam emission direction is the direction of the second directivity DR2B (reference direction), with the direction of the second directivity DR2B being between the direction of the first directivity DR2A and the direction of the third directivity DR2C. By performing correction processing on the second reception information using the first reception information and the third reception information having such directivities, echoes from the reflectors RB5 and RB7 that exists on both sides of the beam emission direction can be suppressed, and lateral resolution can be further improved. Also, with regard to artifacts caused by side lobes, artifacts can be reduced with respect to side lobes on both sides of the main beam.

5. Ultrasonic Measurement Apparatus and Ultrasonic Imaging Apparatus

Next, the present embodiment will be described in detail. Fig. 9 shows exemplary configurations of the ultrasonic measurement apparatus 100 and an ultrasonic imaging apparatus 400 of the present embodiment. The ultrasonic measurement apparatus 100 includes the ultrasonic transducer device 200, a transmission unit 110, a reception unit 120, and the processing unit 130. Also, the ultrasonic imaging apparatus 400 includes the ultrasonic measurement apparatus 100 and a display unit 410.

The ultrasonic transducer device 200 has ultrasonic transducer elements. The ultrasonic transducer elements convert transmission signals, which are electrical signals, into ultrasonic waves, and convert ultrasonic echoes from the subject (object) into electrical signals. The ultrasonic transducer elements may be thin film piezoelectric ultrasonic transducer elements, for example, or may be capacitive micromachined ultrasonic transducers (CMUTs).

The transmission unit 110 performs processing for transmitting ultrasonic beams. Specifically, the transmission unit 110 outputs a transmission signal (drive signal), which is an electrical signal, to the ultrasonic transducer device 200 under the control of the processing unit 130, and the ultrasonic transducer device 200 converts the transmission signal, which is an electrical signal, into an ultrasonic wave and transmits the ultrasonic wave.

The reception unit 120 performs processing for receiving an ultrasonic echo. An ultrasonic echo results from an ultrasonic beam being reflected by the subject. Specifically, the ultrasonic transducer device 200 converts ultrasonic echoes from the object into electrical signals, and outputs the electrical signals to the reception unit 120. The reception unit 120 performs reception processing such as amplification, detection, A/D conversion and phase matching on reception signals (analog signals), which are electrical signals, received from the ultrasonic transducer device 200, and outputs reception data (digital signals), which are the signals obtained from reception processing, to the processing unit 130. Alternatively, the reception unit 120 may output the reception signals (analog signals) obtained from the reception processing to the processing unit 130, without performing A/D conversion.

The processing unit 130 performs processing for controlling the transmission unit 110 and the reception unit 120, and processing for generating ultrasonic images based on the reception signals or reception data from the reception unit 120. Specifically, in the case where reception data is input from the reception unit 120, correction processing is performed on the reception data, and an ultrasonic image is generated from the reception data that has undergone correction processing. Alternatively, in the case where reception signals are input from the reception unit 120, correction processing is performed on the reception signals, A/D conversion is performed on the reception signals that have undergone correction processing, and the digital signals obtained thereby are converted into an ultrasonic image.

The processing unit 130 may be constituted by a dedicated digital signal processor (DSP), for example, or may be constituted by a general-purpose microprocessor (MPU). Alternatively, part or all of the processing that is executed by the processing unit 130 may be executed by a personal computer (PC). In the case where the processing unit 130 also performs analog signal processing, an integrated circuit apparatus that performs amplification and A/D conversion of signals may also be further included.

The display unit 410 is a display device such as a liquid crystal display, for example, and displays ultrasonic images (e.g., B-mode images) generated by the processing unit 130.

6. First Correction Technique

Next, the first technique of correction processing that is performed by the processing unit 130 will be described. Fig. 10A shows exemplary correction processing in the case where the ultrasonic beam BM2 is transmitted.

The first to third directivities DR2A to DR2C schematically represent the directivities of the first to third ultrasonic transducer elements in echo reception. The direction in which reception sensitivity is maximized for each directivity will be referred to as the direction of the directivity (or the directivity direction).

The ultrasonic beam BM2 is transmitted in the depth direction Z, which is the same as the second directivity DR2B. Assume that the reflector RB6 is in front of the ultrasonic beam BM2, and the reflectors RB5 and RB7 are not in front of the ultrasonic beam BM2. Since the reflector RB7 is within the range of the first directivity DR2A and the second directivity DR2B, the amplitudes of the first reception signal RS2A and the second reception signal RS2B increase at time $t_4$. If an increase in amplitude is detected for both reception signals, the amplitude of the second reception signal RS2B is attenuated at time $t_4$.

Detection and attenuation of amplitude are performed as follows, for example. First, detection processing and the like is performed on the first reception signal RS2A and the second reception signal RS2B to extract signals representing amplitude, and the extracted signals are compared with a reference voltage (threshold voltage) by a comparator. In a period during which the comparison results are active for both the first reception signal RS2A and the second reception signal RS2B, the amplitude of the second reception signal RS2B is reduced by an amplification circuit (gain <1).

Similar processing is also performed with regard to the third directivity DR2C. That is, since the reflector RB5 is within the range of the second directivity DR2B and the third directivity DR2C, the amplitudes of the second reception signal RS2B and the third reception signal RS2C increase at time $t_5$. If an increase in amplitude is detected for both reception signals, the amplitude of the second reception signal RS2B is attenuated at time $t_5$.

The second reception signal RS2B whose amplitude has thus been attenuated as described above is taken as the reception signal RS2 corresponding to the ultrasonic beam BM2, and this reception signal RS2 is converted into the pixel line L2 of the B-mode image. For example, the luminance values of the pixels increase as the amplitude of reception signal RS2 increases. In Fig. 10A, high luminance pixels are represented with white squares and low luminance pixels are represented with hatched squares.

Because images of the reflectors RB5 and RB7 are suppressed in the pixels indicated by C1 and C2 on the pixel line L2, the B-mode image will be an image that correctly reflects the actual arrangement of the reflectors RB5 to RB7. In the comparative example shown in Fig. 8, the images are not separated in the B-mode image assuming the reflectors RB5 and RB7 are at the same distance (e.g., $D_4$), whereas the images of the reflectors RB5 and RB7 can be separated by performing the correction processing shown in Fig. 10A. That is, while the lateral resolution was originally restricted due to the width of the ultrasonic beam BM2 as shown in Fig. 8, performing the correction processing shown in Fig. 10A enables a lateral resolution to be obtained as if a beam having a narrower width than the width of the ultrasonic beam BM2 had been transmitted.

As described above, transmission of ultrasonic waves is performed by the second ultrasonic transducer element, and reception of ultrasonic waves is performed by the first to third ultrasonic transducer elements. That is, transmission is performed with the directivity DR2B of the second directivity direction (reference direction) between the first and third directivity directions, and reception is performed with the first to third directivities DR2A to DR2C of the first to third directivity directions.

As a comparative example of the present embodiment, a technique that involves transmitting ultrasonic waves with a plurality of different directivities and obtaining information on each directivity direction using reception signals thereof, for example, is conceivable. However, to realize this technique with the ultrasonic transducer elements of the present embodiment, ultrasonic waves would need to be transmitted by elements in which the piezoelectric layer 60a rides up over the substrate 220 such as shown in Fig. 1. Since the piezoelectric layer 60a expands and contracts greatly at the time of transmission, a large amount of stress is applied to portions of the vibrating film 70a at the boundary FT between the opening 10a and the substrate 220, and the vibrating film 70a could possibly fail.

In this regard, according to the present embodiment, elements in which the piezoelectric layer 60a rides up over the substrate 220 are only used for reception. Since the vibration of the vibrating film 70a is not as great at the time of reception as at the time of transmission, the amount of stress on the boundary FT portions of the vibrating film 70a is also as small. Information on the different directivities can thereby be obtained without elements failing, and correction processing can be performed using this information.

7. Variation of First Correction Technique

Note that, as shown in Fig. 10B, similar correction processing to the above may be performed after converting the first to third reception signals RS2A to RS2C into digital data.

Specifically, the processing unit 130 converts the amplitudes of the first to third reception signals RS2A to RS2C into luminance values, and generates the data of these luminance values as the first to third reception data RD2A to RD2C. For example, the amplitudes at times $t_1$ to $t_5$ are respectively converted into the luminance values of the pixel positions V1 to V5, similarly to a B-mode image. Then, in the case where the first reception data RD2A and the second reception data RD2B are detected, the processing unit 130 performs processing for decreasing the luminance value of the second reception data RD2B at the detected data position. Also, in the case where the second reception data RD2B and the third reception data RD2C are detected, the processing unit 130 performs processing for decreasing the luminance value of the second reception data RD2B at the detected data position. The second reception data RD2B that has undergone processing for decreasing the luminance value as described above is taken as the data of the pixel line L2 of the B-mode image.

The processing for detecting reception data and decreasing luminance values is performed as follows, for example. That is, the luminance value of each pixel of the first to third reception data RD2A to RD2C is compared with a reference value (threshold). In the case where the luminance values exceed the reference value for both the first reception data RD2A and the second reception data RD2B or both the second reception data RD2B and the third reception data RD2C, the luminance value of the second reception data RD2B is decreased at that pixel position (V4 or V5).

The lateral resolution can also be improved according to the above variation, similarly to the case where analog signals are corrected. Also, performing the correction processing by digital signal processing enables the processing to be simplified. Since circuits for processing analog signals such as an amplification circuit and an A/D conversion circuit are no longer necessary, the processing unit 130 can be constituted by only a circuit that performs digital signal processing, and the circuit configuration can be simplified.

8. Second Correction Technique

Next, a second technique of correction processing that is performed by the processing unit 130 will be described. Fig. 11 shows exemplary correction processing in the case where the ultrasonic beams BM1 and BM2 are transmitted. The arrangement of the reflectors is similar to Fig. 10A.

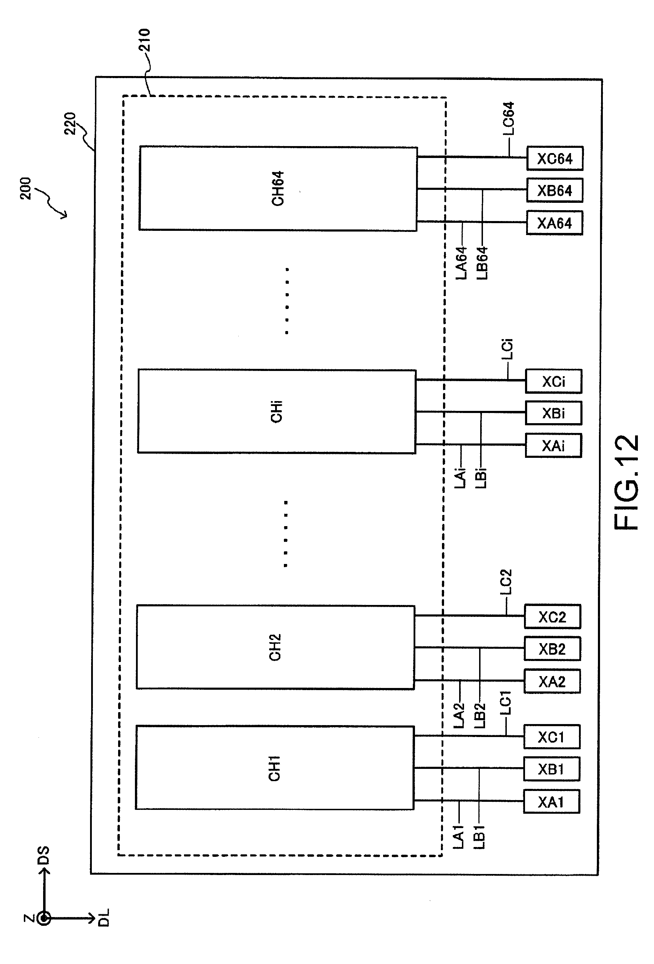

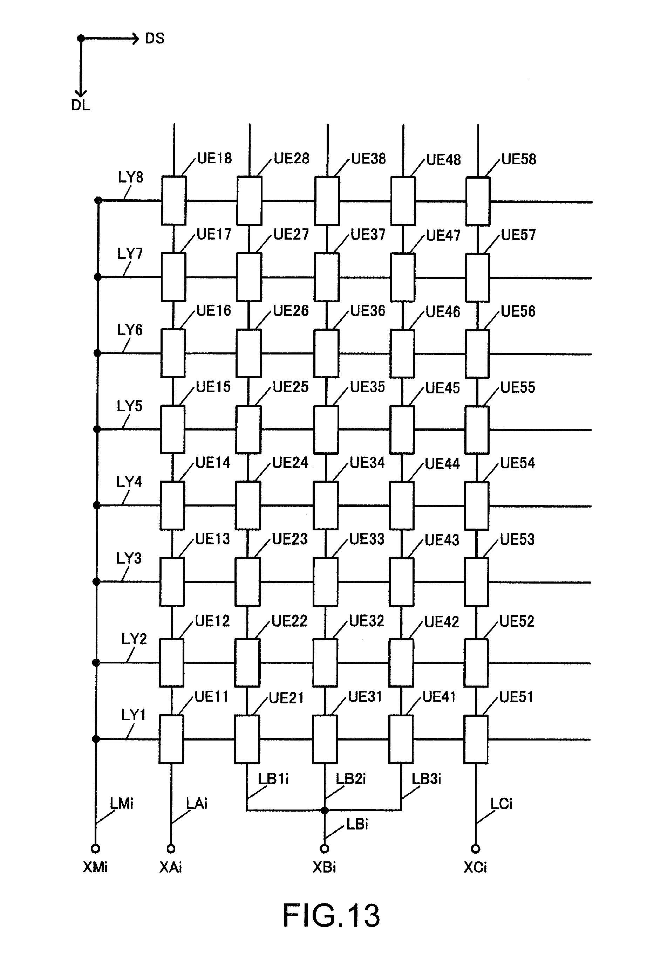

As will be described later with Fig. 12, the ultrasonic transducer device 200 includes 1st to 64th units (channels CH1 to CH64), for example, as 1st to nth units. Each unit includes first ultrasonic transducer elements (UE11 to UE18 in Fig. 13), second ultrasonic transducer elements (UE21 to UE48 in Fig. 13), and third ultrasonic transducer elements (UE51 to UE58 in Fig. 13).

As described with Fig. 7A, in linear scanning, first transmission/reception is performed using the 1st to 8th channels CH1 to CH8, for example, as 1st to kth channels, and second transmission/reception is performed using the 2nd to 9th channels CH2 to CH9, for example, as 2nd to k+1th channels. The first pixel line L1 is obtained in correspondence with the first transmission/reception, and the second pixel line L2 is obtained in correspondence with the second transmission/reception.

In the second technique, the processing unit 130 performs processing for generating an intermediate pixel line L1B between the first pixel line L1A (L1) and the second pixel line L2A (L2). The intermediate pixel line L1B is generated based on first to third reception data RD1A to RD1C obtained in the first transmission/reception.

Further inserting a pixel line between pixel lines in this way is equivalent to virtually increasing the number of channels (narrowing the channel pitch) in the scan direction DS of the ultrasonic transducer element array 210. It thereby becomes possible to create an image of the subject with a narrower pitch.

Specifically, the processing unit 130 converts the amplitudes of first to third reception signals RS1A to RS1C into luminance values, and generates the first to third reception data RD1A to RD1C. In the case where the first reception data RD1A and the second reception data RD1B are detected, the processing unit 130 performs processing for decreasing the luminance value of the second reception data RD1B. Also, the processing unit 130 performs processing for maintaining or increasing the luminance value of the first reception data RD1A.

In the example shown in Fig. 11, the first reception signal RS1A and the second reception signal RS1B both have large amplitudes at time $t_5$, and the first reception data RD1A and the second reception data RD1B both have high luminance values at the pixel position V5, in correspondence with the reflector RB5. The processing unit 130, having detected this, decreases the luminance value of the second reception data RD1B at the pixel position V5, and generates this second reception data RD1B as the first pixel line L1A. Also, the processing unit 130 maintains or increases the luminance value of the first reception data RD1A at the pixel position V5, and generates this first reception data RD1A as the intermediate pixel line L1B. Note that detection of luminance values and the like can be realized with a similar technique to the variation of the first correction technique.

Thus, in the B-mode image, the luminance of the pixel indicated by E4 is suppressed, and the luminance of the pixel indicated by E5 is maintained or increased.

Also, the processing unit 130 performs processing for generating the intermediate pixel line L2C between the first pixel line L1A and the second pixel line L2A. The intermediate pixel line L2C is generated based on the first to third reception data RD2A to RD2C obtained in the second transmission/reception.

Specifically, in the case where the first reception data RD2A and the third reception data RD2C are detected, the processing unit 130 performs processing for decreasing the luminance value of the second reception data RD2B, and generates the second pixel line L2A. Also, the processing unit 130 performs processing for maintaining or increasing the luminance value of the third reception data RD2C, and generates the intermediate pixel line L2C.

Because the luminance values of the second reception data RD2B and the third reception data RD2C are high at the pixel position V5, the luminance of the pixel indicated by E6 will be suppressed and the luminance of the pixel indicated by E7 will be maintained or increased in the B-mode image.

When the comparative example shown in Fig. 8 is applied to Fig. 11, the image of the reflector RB5 will appear in the pixel lines L1C to L2A at the pixel position V5 of the B-mode image. That is, the image spreads (fades out) in the scan direction due to the width of the ultrasonic beam. In this regard, because the image of the reflector RB5 appears in the pixel lines L1A and L2C in the case where the second correction technique is used, the width of the image in the scan direction is narrower than the comparative example. That is, the influence of the spread of the ultrasonic beams is reduced, and lateral resolution improves.

Note that either the first correction technique or the second correction technique mentioned above may be used, or these techniques may be used in combination. In the case of combining the techniques, an ultrasonic image may, for example, be generated using the first correction technique in regions close to the ultrasonic transducer element array 210 in the depth direction Z, and the second correction technique in regions at a distance from the ultrasonic transducer element array 210.

The first correction technique is considered to be highly effective at reducing artifacts caused by side lobes because of directly suppressing echoes from reflectors that are not in front of the beam. Because the arrival distance of the side lobes is shorter than the main beam, artifacts can be effectively reduced by using the first correction technique in regions close to the ultrasonic transducer element array 210. Also, because the width of an ultrasonic beam has a tendency to spread when the ultrasonic beam passes the focus, lateral resolution can be effectively improved by using the second correction technique in regions at a distance from the ultrasonic transducer element array 210.

9. Ultrasonic Transducer Device

Fig. 12 shows an exemplary configuration of the ultrasonic transducer device 200 that is used in the abovementioned correction technique.

Note that, hereinafter, the case where there are 64 channels will be described as an example, but the ultrasonic transducer device 200 may include 1st to nth channels other than n = 64. Also, hereinafter, the case where signal terminals are disposed on one edge of the ultrasonic transducer device 200 will be described as an example, but signal terminals may be disposed on the edges on both sides of the ultrasonic transducer device 200, and signals may be input and output from both sides.

The ultrasonic transducer device 200 includes the substrate 220, the ultrasonic transducer element array 210 formed on the substrate 220, the signal terminals XA1 to XA64, XB1 to XB64 and XC1 to XC64 formed on the substrate 220, and the signal electrode lines LA1 to LA64, LB1 to LB64 and LC1 to LC64 formed on the substrate 220.

Signal terminals XAi, XBi and XCi (where i is a natural number such that $1 \leq i \leq n = 64$) are disposed on one edge of the ultrasonic transducer element array 210 in the slice direction DL. The signal terminals XAi, XBi and XCi are respectively connected to one end of signal electrode lines LAi, LBi and LCi. For example, the substrate 220 is a rectangle whose long sides are in the scan direction DS, and the signal terminals XAi, XBi and XCi are disposed along one long sides of the rectangle.

Here, the slice direction DL and the scan direction DS represent directions in a plane looking at the substrate 220 from the thickness direction (depth direction Z). The scan direction DS corresponds to the direction in which ultrasonic beams are scanned in the scanning operation of linear scanning, sector scanning, or the like. The slice direction DL is a direction that intersects (e.g., is orthogonally to) the scan direction DS, and, in the case where an ultrasonic beam is scanned to obtain a cross-sectional image, for example, corresponds to a direction that is orthogonal to the cross-section.

The ultrasonic transducer element array 210 includes the channels CH1 to CH64 disposed in the scan direction DS. Each channel CHi is constituted by a plurality of ultrasonic transducer elements electrically connected to one of the signal electrode lines LAi, LBi and LCi.

10. Channels

Fig. 13 shows a detailed exemplary configuration of a channel CHi. The channel CHi includes ultrasonic transducer elements UE11 to UE58 that are disposed in a matrix having eight rows in the slice direction DL and five columns in the scan direction DS.

The ultrasonic transducer elements UE11 to UE18 of the first column have the first directivity, the ultrasonic transducer elements UE21 to UE48 of the second to fourth columns have the second directivity, and the ultrasonic transducer elements UE51 to UE58 of the fifth column have the third directivity. Note that the arrangement of the directivities is not limited thereto, and, for example, the ultrasonic transducer elements UE11 to UE18 of the first column may have the third directivity, and the ultrasonic transducer elements UE51 to UE58 of the fifth column may have the first directivity.

One of the electrodes (e.g., first electrode layers 40a to 40c shown in Figs. 1 to 3) of the ultrasonic transducer elements of the first to fifth columns is respectively connected to the signal electrode lines LAi, LB1i, LB2i, LB3i and LCi. The signal electrode lines LB1i, LB2i and LB3i are wired in the slice direction DL, and are connected to the signal electrode line LBi.

The other of the electrodes (e.g., second electrode layer 50 shown in Figs. 1 to 3) of the ultrasonic transducer elements of the first to eighth rows is respectively connected to common electrode lines LY1 to LY8. The common electrode lines LY1 to LY8 are wired in the scan direction DS, and are connected to a common electrode line LMi. The common electrode line LMi is wired in the slice direction DL, and is connected to a common terminal XMi. The common terminal XMi is formed on the substrate 220, and is, for example, disposed on the same side as the side on which the signal terminals XAi and the like are disposed.

In the above channel CHi, transmission and reception of ultrasonic waves are performed as follows. The transmission unit 110 supplies a transmission signal (e.g., voltage pulse) to the signal terminal XBi, and the ultrasonic transducer elements UE21 to UE48 convert the transmission signal into ultrasonic waves. The ultrasonic transducer elements UE11 to UE58 then convert ultrasonic echoes that are reflected by the object into reception signals (e.g., voltage signals), and the reception signals are output from the signal terminals XAi to XCi. The reception unit 120 receives the reception signals from the signal terminals XAi to XCi, and performs reception processing on the reception signals. Note that the transmission unit 110 or the reception unit 120 supplies a common voltage (e.g., fixed voltage) to the common terminal XMi.

Note that although the case where the ultrasonic transducer elements are disposed in a matrix having eight rows and five columns was described above as an example, the invention is not limited thereto, and the ultrasonic transducer elements may be disposed in a matrix of M rows and N columns (where M and N are natural numbers of two or more) other than eight rows and five columns. In this case, the ultrasonic transducer element array 210 is a matrix of M rows and (nxN) columns.

Also, the ultrasonic transducer element array 210 is not limited to a matrix arrangement. For example, a mixture of channels having different numbers of elements in the slice direction DL may be provided, or elements need not be disposed linearly in the scan direction DS and the slice direction DL (e.g., may be disposed in a staggered pattern).

Also, although the ultrasonic transducer elements having the first directivity, the second directivity and the third directivity are respectively disposed to one column, three columns and one column in the above description, the invention is not limited thereto, and these ultrasonic transducer elements may respectively be disposed in a plurality of two or more columns, one or a plurality of columns other than three columns, and a plurality of two or more columns.

11. Ultrasonic Imaging Apparatus and Ultrasonic Probe

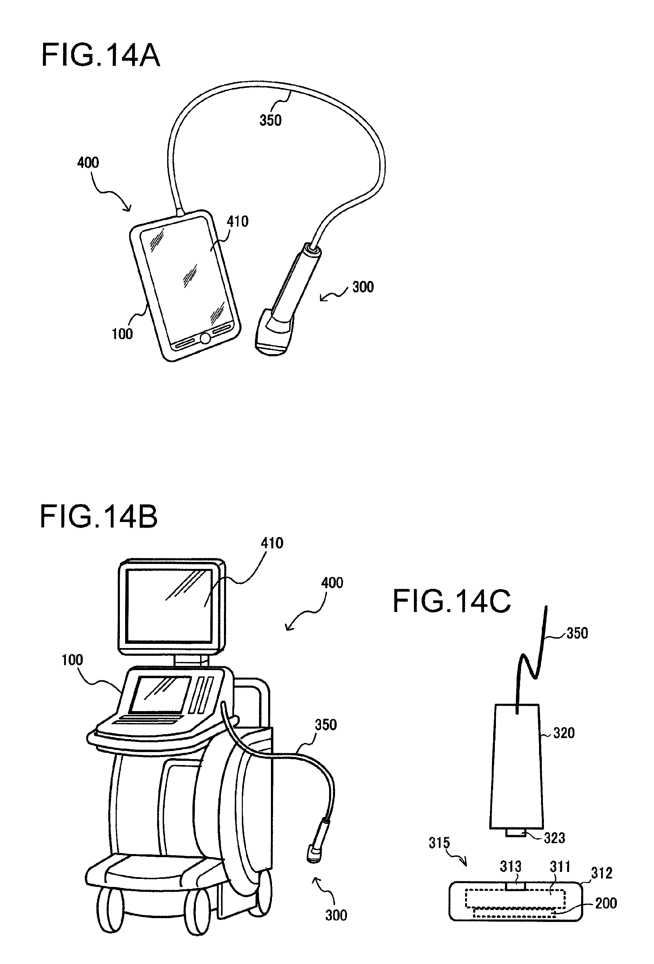

Fig. 14A shows a portable ultrasonic imaging apparatus 400, and Fig. 14B shows a stationary ultrasonic imaging apparatus 400.

The portable and stationary ultrasonic imaging apparatuses 400 both include the ultrasonic measurement apparatus 100, an ultrasonic probe 300, a cable 350, and the display unit 410. The ultrasonic probe 300 includes the ultrasonic transducer device 200, and is connected to the ultrasonic measurement apparatus 100 by the cable 350. The display unit 410 displays image data for display.

Any of the transmission unit 110, the reception unit 120 and the processing unit 130 that are included in the ultrasonic measurement apparatus 100 can instead be provided in the ultrasonic probe 300.

Fig. 14C shows a specific exemplary configuration of the ultrasonic probe 300. The ultrasonic probe 300 includes a probe head 315 and a probe body 320, and, as shown in Fig. 14C, the probe head 315 is detachable from the probe body 320.

The probe head 315 includes the ultrasonic transducer device 200, a probe base substance 311, a probe casing 312, and a probe-head side connector 313.

The probe body 320 includes a probe-body side connector 323. The probe-body side connector 323 is connected to the probe-head side connector 313. The probe body 320 is connected to the ultrasonic measurement apparatus 100 by the cable 350. Note that any of the transmission unit 110 and the reception unit 120 that are included in the ultrasonic measurement apparatus 100 can instead be provided in the probe body 320.

Note that although the present embodiment has been described in detail above, a person skilled in the art will appreciate that numerous modifications can be made without substantially departing from the novel matter and effects of the invention. Accordingly, all such modifications are within the scope of the invention. For example, terms that appear in the description or drawings at least once together with other broader or synonymous terms can be replaced by those other terms at any place within the description or drawings. All combinations of the present embodiment and the modifications are also within the scope of the invention. Also, the configurations and operations of the ultrasonic measurement apparatus and the ultrasonic imaging apparatus, the method of processing ultrasonic images, and the like are not limited to those described in the present embodiment, and various modifications can be made.

**Claims**

1.    An ultrasonic transducer device comprising:

a substrate (220) in which a first opening (10a) and a second opening (10b) are provided;
a first ultrasonic transducer element that is formed on the substrate (220) in correspondence with the first opening (10a); and
a second ultrasonic transducer element that is formed on the substrate (220) in correspondence with the second opening (10b);
wherein the first opening (10a) has a first edge portion (EDA) on a first direction side and a second edge portion (EDB) on a second direction side, the first direction corresponding to a scan direction and the second direction being in the opposite direction to the first direction, and
the first ultrasonic transducer element includes:

a first vibrating film (70a) that blocks the first opening (10a); and
a first piezoelectric layer (60a) that is provided on the first vibrating film (70a) so as to cover the first edge portion (EDA) of the first opening (10a) in plan view from a thickness direction of the substrate (220).

2.    The ultrasonic transducer device according to claim 1, wherein the second ultrasonic transducer element includes:

a second vibrating film (70b) that blocks the second opening (10b); and
a second piezoelectric layer (60b) that is provided on the second vibrating film (70b) without overlapping with either a third edge portion (EDC) on the first direction side or a fourth edge portion (EDD) on the second direction side of the second opening (10b) in the plan view.

3.    The ultrasonic transducer device according to claim 1 or 2,
wherein the first ultrasonic transducer element receives an ultrasonic wave with a directivity that is in a direction inclined to the first direction side relative to a reference direction, and
the second ultrasonic transducer element receives an ultrasonic wave with a directivity that is in the reference direction.

4.    The ultrasonic transducer device according to any one of claims 1, 2 or 3, wherein the first vibrating film (70a) and the second vibrating film (70b) are formed in a same plane.

5.    The ultrasonic transducer device according to any one of claims 1 to 4, comprising:

a third ultrasonic transducer element that is formed on the substrate (220) in correspondence with a third opening (10c) that is provided in the substrate (220),
wherein the third ultrasonic transducer element includes:

a third vibrating film (70c) that blocks the third opening (10c); and
a third piezoelectric layer (60c) that is provided on the third vibrating film (70c) so as to cover, out of a fifth edge portion on the first direction side and a sixth edge portion on the second direction side of the third opening (10c), the sixth edge portion in the plan view.

**6.** The ultrasonic transducer device according to claim 5,
wherein the first ultrasonic transducer element receives an ultrasonic wave with a directivity that is in a direction inclined to the first direction side relative to the reference direction, and
the third ultrasonic transducer element receives an ultrasonic wave with a directivity that is in a direction inclined to the second direction side relative to the reference direction.

**7.** The ultrasonic transducer device according to claim 5 or 6, wherein the first vibrating film (70a) and the third vibrating film (70c) are formed in a same plane.

**8.** The ultrasonic transducer device according to any one of claims 1 to 7, wherein an area of the first piezoelectric layer (60a) over the first opening (10a) is greater than an area of the first piezoelectric layer (60a) over the substrate (220) in the plan view.

**9.** An ultrasonic transducer device comprising:

a first ultrasonic transducer element that has directivity in a first directivity direction that differs from a reference direction, and performs ultrasonic wave reception, and
a second ultrasonic transducer element that has directivity of a second directivity direction that is the reference direction, and performs ultrasonic wave transmission or ultrasonic wave transmission and reception.

**10.** The ultrasonic transducer device according to any one of claims 1 to 8, wherein
the first ultrasonic transducer element has directivity in a first directivity direction that differs from a reference direction, and performs ultrasonic wave reception, and
the second ultrasonic transducer element has directivity of a second directivity direction that is the reference direction, and performs ultrasonic wave transmission or ultrasonic wave transmission and reception.

**11.** The ultrasonic transducer device according to claim 9 or 10, comprising:

a third ultrasonic transducer element that has directivity of a third directivity direction that differs from the reference direction, and performs ultrasonic wave reception,
wherein the reference direction is a direction between the first directivity direction and the third directivity direction.

**12.** An ultrasonic measuring apparatus comprising:

the ultrasonic transducer device according to any one of claims 1 to 11; and
a processing unit that generates an ultrasonic image based on a first reception signal received by the first ultrasonic transducer element.

**13.** An ultrasonic measuring apparatus comprising:

the ultrasonic transducer device according to any one of claims 1 to 11; and
a processing unit that performs processing for correcting second reception information which is a second reception signal received by the second ultrasonic transducer element or second reception data that is obtained from the second reception signal, using first reception information which is a first reception signal received by the first ultrasonic transducer element or first reception data that is obtained from the first reception signal.

**14.** An ultrasonic imaging apparatus comprising:

the ultrasonic transducer device according to any one of claims 1 to 11;
a processing unit that generates an ultrasonic image based on a first reception signal received by the first ultrasonic transducer element; and
a display unit that displays the ultrasonic image.

FIG. 1

FIG. 2

FIG. 3

# FIG. 4A

# FIG. 4B

# FIG. 4C

$$PCR = \frac{WP}{WC} = 80\%$$

$$PCR = \frac{WP}{WC} = 60\%$$

FIG. 5A

FIG. 5B

FIG. 6A

FIG. 6B

FIG. 6C

FIG. 6D

FIG. 6E

FIG. 6F

# FIG. 7A

DL
DS

210

CH1
CH2
CH3
CH4
CH5
CH6
CH7
CH8
CH9
CH10
CH11
CH12
CH13

BM1
BM2
BM3
BM4

B-MODE IMAGE

L1
L2
L3
L4
L5
L6
L7
L8
L9

# FIG. 7B

DL
DS

210

RB1
RB2
RB3
RB4

RECEPTION SIGNAL

RS1
RS2
RS3
RS4
RS5
RS6
RS7
RS8
RS9

B-MODE IMAGE

L1
L2
L3
L4
L5
L6
L7
L8
L9

V1 V2 V3 V4 V5

$D_1$ $D_2$ $D_3$ $D_4$ $D_5$

$t_0$ $t_1$ $t_2$ $t_3$ $t_4$ $t_5$

FIG. 8

**FIG. 9**

# FIG.10A

# FIG.10B

EP 2 883 623 A2

FIG.11

FIG.12

EP 2 883 623 A2

FIG.13

## FIG.14A

## FIG.14B

## FIG.14C

## REFERENCES CITED IN THE DESCRIPTION

**Patent documents cited in the description**

• JP 2012523920 A